Europäisches Patentamt

(19) European Patent Office

Office européen des brevets

(11) Publication number: **0 460 955 A1**

## (12) EUROPEAN PATENT APPLICATION

(21) Application number: **91305124.9**

(22) Date of filing: **06.06.91**

(51) Int. Cl.⁵: **H01L 21/68, H01L 21/00, H02N 13/00**

(30) Priority: **08.06.90 US 535384**

(43) Date of publication of application:
**11.12.91 Bulletin 91/50**

(84) Designated Contracting States:
**DE FR GB IT NL**

(71) Applicant: **VARIAN ASSOCIATES, INC.**
**3100 Hansen Way**
**Palo Alto, California 94304-1030 (US)**

(72) Inventor: **Fritiger, William A.**
**10 Butterworth Road**
**Beverly, Massachusetts 01915 (US)**

(74) Representative: **Cline, Roger Ledlie et al**
**EDWARD EVANS & CO. Chancery House 53-64**
**Chancery Lane**
**London WC2A 1SD (GB)**

(54) **Clamping a workpiece utilizing polyphase clamping voltage.**

(57) Apparatus for electrostatic clamping of a workpiece such as a semiconductor wafer in a vacuum processing chamber wherein an ion beam is applied to the wafer is provided. In one embodiment, the apparatus includes an electrically conductive platen, a resilient, thermally-conductive dielectric layer affixed to the platen and one or more conductive wires positioned on the clamping surface. The wires protrude at least slightly above the clamping surface except when the wafer is clamped thereon. A clamping voltage is applied between the wires and the platen to firmly clamp the wafer against the clamping surface and depress the wires into the resilient dielectric layer. The clamping voltage preferably comprises a bipolar square wave in the frequency range of less than one Hz to 300 Hz and having a switching rate of about 1000 volts per millisecond or less to limit charging current to the wafer and thereby prevent arcing. In another embodiment, a three-phase wafer clamping apparatus includes a platen divided into three electrically-isolated sections. One phase of a three-phase clamping voltage is connected to each of the platen sections. In the three-phase configuration, the wafer charging current is very small, and the clamping force is essentially constant.

EP 0 460 955 A1

FIG. 8

This application discloses, but does not claim, subject matter whch is closed in simultaneously filed Application No.

(Reference EP12078).

This apparatus relates to apparatus for processing workpieces such as semiconductor wafers in which the workpiece is clamped. It is useful in a vacuum processing chamber, for example in ion implantation systems but is not limited to such use.

In the fabrication of integrated circuits, a number of well-established processes involve the application of ion beams to semiconductor wafers in vacuum. These processes include, for example, ion implantation; ion beam milling and reactive ionetching. In each instance, a beam of ions is generated in a source and is directed with varying degrees of acceleration toward a target wafer. Ion implantation has become a standard technique for introducing conductivity-altering impurities into semiconductor wafers. A desired impurity material is ionized in an ion source, the ions are accelerated to form an ion beam of prescribed energy and the ion beam is directed at the surface of the wafer. The energetic ions in the beam penetrate into the bulk of the semiconductor material and are embedded in the crystalline lattice of the semiconductor material to form a region of desired conductivity.

The target mounting site is a critical part of an ion implantation system. The target mounting site is required to firmly clamp a semiconductor wafer in a fixed position for ion implantation and, in most cases, to provide cooling of the wafer. In addition, means must be provided for exchanging wafers after completion of ion implantation. Cooling of wafers is particularly important in commercial semiconductor processing wherein a major objective is to achieve a high throughput in terms of wafers processed per unit time. One way to achieve high throughput is to use a high current ion beam so that the implantation process is completed in a shorter time. However, large amounts of heat are likely to be generated by the high current ion beam. The heat can result in uncontrolled diffusion of impurities beyond prescribed limits in the wafer and in degradation of patterned photoresist layers. It is usually necessary to provide wafer cooling in order to limit the maximum wafer temperature to about 100°C.

A number of techniques for clamping a semiconductor wafer at the target mounting site are known in the art. According to one well-known technique, the wafer is clamped against a platen by a peripheral clamping ring which engages the outer periphery of the front surface of the wafer. The front surface of the wafer is exposed for ion implantation. However, the outer periphery of the wafer cannot be utilized for integrated circuit devices since the clamping ring blocks ion implantation of that portion of the wafer. Another disadvantage is that peripheral clamping does not result in physical contact between the wafer and a conventional flat metal platen over the entire wafer surface area. Since the wafer does not physically contact a large percentage of the platen surface that is intended for thermal transfer, the rate of thermal transfer from the semiconductor wafer is significantly reduced in a vacuum environment. Heat transfer by radiation from the wafer is inadequate, except for low current ion beams. In the case of high current ion beams, physical contact between the wafer and the platen over the area of the wafer is required to ensure sufficient cooling by conductive thermal transfer.

A variety of techniques have been disclosed for ensuring a high rate of thermal transfer with peripheral clamping. A contoured heat sink surface for optimizing conductive heat transfer between a wafer and a heat sink is disclosed in U.S. Patent No. 4,535,835, issued August 20, 1985 to Holden. The heat sink surface is contoured so as to impose a load that results in a uniform contact pressure distribution and a stress approaching the elastic limit of the wafer for a peripherally-clamped wafer.

Another prior art technique for thermal transfer in vacuum involves the use of a thermally-conductive polymer between a semiconductor wafer and a heat sink. A tacky, inert polymer film for providing thermal contact between a wafer and a heat sink is disclosed in U.S. Patent No. 4,139,051, issued February 13, 1979 to Jones et al. The polymer film disclosed by Jones et al has a sticky surface which is used to advantage to retain the wafer in position during processing. Such a sticky surface is unacceptable in automated processing wherein the wafer must easily be removed after ion beam treatment. The sticky surface can result in wafer breakaqe and can easily become contaminated.

An automated wafer clamping mechanism utilizing a pliable, thermally-conductive layer between a semiconductor wafer and a heat sink is disclosed in U.S. Patent No. 4,282,924 issued August 11, 1981 to Faretra. The wafer is clamped at its periphery to a convexly-curved platen having a layer of thermally-conductive silicone rubber on its surface.

The technique of gas conduction has also been utilized for wafer cooling in vacuum. Gas is introduced into a cavity or microscopic voids behind a semiconductor wafer and effects thermal coupling between the wafer and a heat sink. Gas-assisted, solid-to-solid thermal transfer with a semiconductor wafer is disclosed in U.S. Patent No. 4,457,359, issued July 3, 1984 to Holden.

All of the known prior art peripheral clamping techniques result in wasted wafer area. In many of these configurations, thermal transfer is inadequate due to poor contact between the semiconductor wafer and the platen surface. Furthermore, the curved platens disclosed in the aforementioned Patent Nos. 4,535,835 and 4,282,924 introduce a variation in the angle of incidence of the ion beam on the wafer surface for different locations on the wafer surface. In ion implantation, variations in incidence angle can be a serious problem. The depth of penetration of incident ions is a function of incidence angle because of the well-known channeling effect. Therefore, it is desirable in ion implantation to provide a constant angle of incidence of the ion beam on the wafer surface over the surface area of the semiconductor wafer.

A wafer clamping technique which eliminates the requirement for a peripheral clamping ring and which permits use of a flat platen surface is centrifugal clamping. In centrifugal clamping, the wafer site is rotated about an axis of rotation. The platen surface is oriented at an angle with respect to the axis of rotation so that centrifugal force presses the wafer against the platen surface. A thermal transfer technique which utilizes centrifugal clamping and a flat platen surface having a pliable, thermally-conductive polymer layer for effecting thermal transfer is disclosed in U.S. Patent No. 4,832,781, issued May 23, 1989 to Mears. The disclosed technique provides highly satisfactory cooling performance. However, the requirement for rotating the wafer site in order to provide centrifugal clamping adds complexity and is not always practical.

Another known technique for clamping semiconductor wafers involves the use of electrostatic forces. A dielectric layer is positioned between a semiconductor wafer and a conductive support plate. A voltage is applied between the semiconductor wafer and the support plate, and the wafer is clamped against the dielectric layer by electrostatic forces. An electrostatic wafer clamp is disclosed by G.A. Wardly in "Electrostatic Wafer Chuck for Electron Beam Microfabrication", Rev. Sci. Instrum., Vol. 44, No. 10, Oct. 1972, pp. 1506-1509 and in U.S. Patent No. 3,993,509 issued November 23, 1976 to McGinty. Electrostatic wafer clamp arrangements which utilize a thermally-conductive material to remove heat from the wafer are disclosed in U.S. Patent No. 4,502,094, issued February 26, 1985 to Lewin et al, U.S. Patent No. 4,665,463, issued May 12, 1987 to Ward et al and U.S. Patent No. 4,184,188, issued January 15, 1980 to Briglia. The Briglia patent discloses a support plate having layers of thermally-conductive, electrically-insulative RTV silicone. Electrostatic wafer clamps are also disclosed in U.S. Patent No. 4,480,284, issued October 30, 1984 to Tojo et al, U.S. Patent No. 4,551,611, issued November 19, 1985 to Lewin, U.S. Patent No. 4,724,510, issued February 9, 1988 to Wicker et al and U.S. Patent No. 4,412,133, issued October 25, 1983 to Eckes et al.

Problems associated with prior art electrostatic wafer clamping arrangements include inadequate clamping force, difficulty in making electrical contact to the semiconductor wafer, and wafer sticking to the platen after the clamping voltage has been removed. In addition, thermal transfer characteristics have usually been inadequate for high current ion implantation applications, since a significant portion of the platen surface area is devoted to making electrical contact with the semiconductor wafer. See, for example, the aforementioned Patent No. 4,502,094.

According to the invention there is provided apparatus for electrostatic clamping of a workpiece as set out in Claim 1. The workpiece is preferably a semiconductor wafer and the clamping surface is preferably generally circular with the platen sections generally sector-shaped. Good results have been obtained with three phases of clamping voltage and three platen sections.

The dielectric material is preferably a resilient dielectric layer adhered to the platen sections and is typically a thermally-conductive silicone rubber to provide cooling of the semiconductor wafer.

The three-phase wafer clamping apparatus can be operated without a ground connection to the semiconductor wafer, since the platen means and the wafer are configured as a Y-connected, symmetrical load on the three-phase source, and the ground current is zero. In practice, it is usually desirable to provide a ground connection to the wafer, since the circuit is likely to be somewhat unbalanced. The ground connection limits charging of the wafer due to an ion beam and permits measurement of the ion beam that is incident upon the semiconductor wafer. A preferred ground connection includes one or more thin wires lightly stretched across the resilient dielectric layer.

Each phase of the three-phase clamping voltage can comprise a sinusoidal voltage. Alternatively, each phase of the three-phase clamping voltage can comprise a bipolar square wave voltage. The switching rate of the square wave voltage is preferably limited to about 1000 volts per millisecond or less to prevent arcing between the wire and the semiconductor wafer during clamping.

The three-phase wafer clamping apparatus provides a substantially constant clamping force as a function of time. The ground connection to the semiconductor wafer can be eliminated, if desired. When a ground connection to the wafer is utilized, the requirement for a low resistance contact can be relaxed. The risk of arcing between the wafer and the ground connection during clamping is minimized.

Examples of the invention will now be described with reference to the accompanying drawings in which:-

FIG. 1 is a schematic plan view of electrostatic wafer clamping apparatus;

FIG. 2 is a cross-sectional view, taken along line 2-2 of FIG. 1, of the wafer clamping apparatus of FIG. 1 with a semiconductor wafer positioned above the clamping surface;

FIG. 3 is a cross-sectional view of the wafer clamping apparatus of FIG. 1 with a semiconductor wafer positioned on the clamping surface;

FIG. 4A is an enlarged, partial cross-sectional view of the wafer, the thermally-conductive dielectric layer and the conductive platen, showing the contact wire protruding above the clamping surface;

FIG. 4B is an enlarged, partial cross-sectional view of the wafer, the thermally-conductive dielectric layer and the conductive platen, showing the contact wire pressed into the dielectric layer;

FIG. 5 is a graph which illustrates a preferred clamping voltage as a function of time;

FIG. 6 is a plan view of an example of an electrostatic wafer clamping apparatus;

FIG. 7 is a partial cross-sectional view, taken along line 7-7 of FIG. 6, of the wafer clamping apparatus of FIG. 6.

FIG. 8 is a schematic plan view of an electrostatic wafer clamping apparatus which utilizes a three-phase clamping voltage; and

FIG. 9 is a graph which illustrates the phases of a three-phase sine wave clamping voltage suitable for use in the wafer clamping apparatus of FIG. 8;

FIG. 10 is an equivalent circuit of the wafer clamping apparatus shown in FIG. 8; and

FIG. 11 is a graph which illustrates the phases of a three-phase square wave clamping voltage suitable for use in the wafer clamping apparatus of FIG. 8.

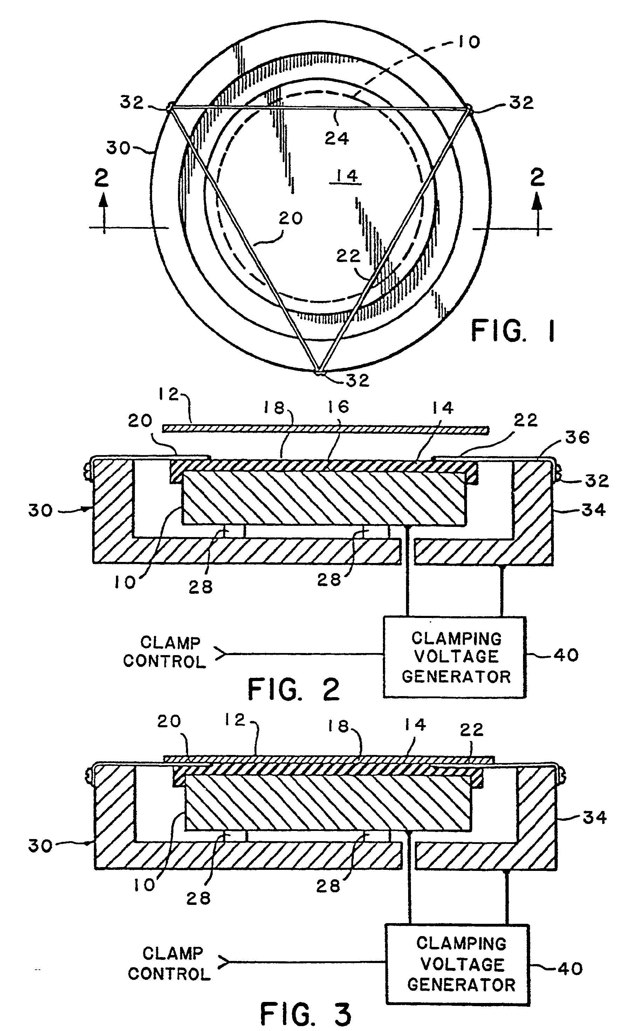

In the embodiment of Figures 1 to 3, an electrically conductive platen 10 provides mechanical support for a semiconductor wafer 12. The platen 10 is typically an aluminum disk and may be provided with passages (not shown) for circulation of a cooling fluid. A dielectric layer 14 is affixed to a surface 16 of platen 10. The surface 16 is typically flat. The dielectric layer 14 has a flat wafer clamping surface 18. The dielectric layer 14 is a soft, resilient material and is preferably a thermally-conductive dielectric material, as described in detail hereinafter.

Conductive wires 20, 22 and 21 are lightly stretched across clamping surface 18 and are attached to a frame member 30. The wires 20, 22 and 24 lie generally in the plane of clamping surface 18 and protrude at least slightly above clamping surface 18. The wires 20, 22 and 24 can be secured to frame member 30 by suitable connection means such as screws 32 to ensure electrical contact with frame member 30. The platen 10 is electrically isolated from frame member 30 by appropriate insulating means such as insulating standoffs 28.

In the embodiment of FIGS. 1-3, the frame member 30 is cup-shaped and has an upstanding wall 34 which surrounds platen 10. The wires 20, 22, 24 are stretched across a top surface 36 of wall 31. The top surface 36 of wall 34 is located relative to clamping surface 18 such that wires 20, 22 and 24 are positioned on clamping surface 18. A clamping voltage generator 40 has an output connected between platen 10 and frame member 30. A clamp control signal controls the operation of clamping voltage generator 40. When the clamp control signal is in an active state, a clamping voltage, as described hereinafter, is applied between platen 10 and wires 20, 22 and 24.

The wafer 12 can be positioned on clamping surface 18 by any suitable wafer handling system. The wafer 12 is shown in FIG. 2 positioned above clamping surface 18 and is shown in FIG. 3 clamped to surface 18. In a preferred wafer handling system, the wafer 12 is placed by a wafer pick on three wafer support pins (not shown) which extend through platen 10 and dielectric layer 14. The pins are then retracted into platen 10 so that the wafer 12 is lowered onto the clamping surface 18. A waferghandling mechanism of this type is disclosed in U.S. Patent No. 4,817,556, issued April 4, 1989 to Mears et al.

When the wafer 12 has been positioned on the clamping surface 18 of dielectric layer 14, the clamping voltage generator 40 is activated, causing the application of a clamping voltage between wires 20, 22, 24 and platen 10. As shown in FIG. 2, the wires 20, 22 and 24 protrude at least slightly above clamping surface 18 except when the wafer 12 is firmly clamped in position. The wires 20, 22 and 24, electrically contact wafer 12 along at least portions of their length. When the clamping voltage is applied, the wafer 12 is drawn firmly against clamping surface 18 by electrostatic forces, and the wires 20, 22 and 24 are pressed into the resilient dielectric layer 14. The wafer 12, the platen 10 and the dielectric layer 14 form a parallel plate capacitor. It is well known that application of a voltage between the plates of a parallel plate capacitor produces an electrostatic force which attracts the plates toward each other.

The dielectric layer 14 is a soft, thermally-conductive polymer layer having a thin, hard surface film. The soft polymer layer, which is preferably a silicone rubber containing thermally-conductive particles, conforms to surface irregularities on the wafer and has low thermal resistance. The surface film is preferably silicon dioxide which prevents adherence, both of the wafer and of foreign matter, to the silicone rubber layer. The silicone rubber layer preferably has a thickness in the range of about 0.008 cm to 0.025 cm and may be molded in place on the surface of platen 10. Further details regarding the silicone rubber layer and techniques for fabrication thereof are provided in the aforementioned U.S. Patent No. 4,832,781, which is hereby incorporated by reference. The silicone rubber layer is extremely soft and typically has a hardness of durometer value 50 shore A or less.

The soft, silicone rubber layer is used to advantage in providing a secure and low-resistance electrical contact to semiconductor wafer 12. The wires 20, 22 and 24 are formed of an electrical conductor which is relatively strong and is resistant to oxidation. A preferred material is tungsten. Other suitable materials include molybdenum and noble metals such as gold and platinum. The wire diameter is typically in the range of about 0.002 cm to 0.008 cm. A preferred wire diameter is about 0.0025 cm. The wire diameter must be sufficiently large to carry the charging current associated with operation of the wafer clamp. In addition, the wire diameter must be sufficient to ensure durability during multiple clamping operations. However, the wire diameter must not be so great that it damages the dielectric layer 14 or degrades its thermal performance.

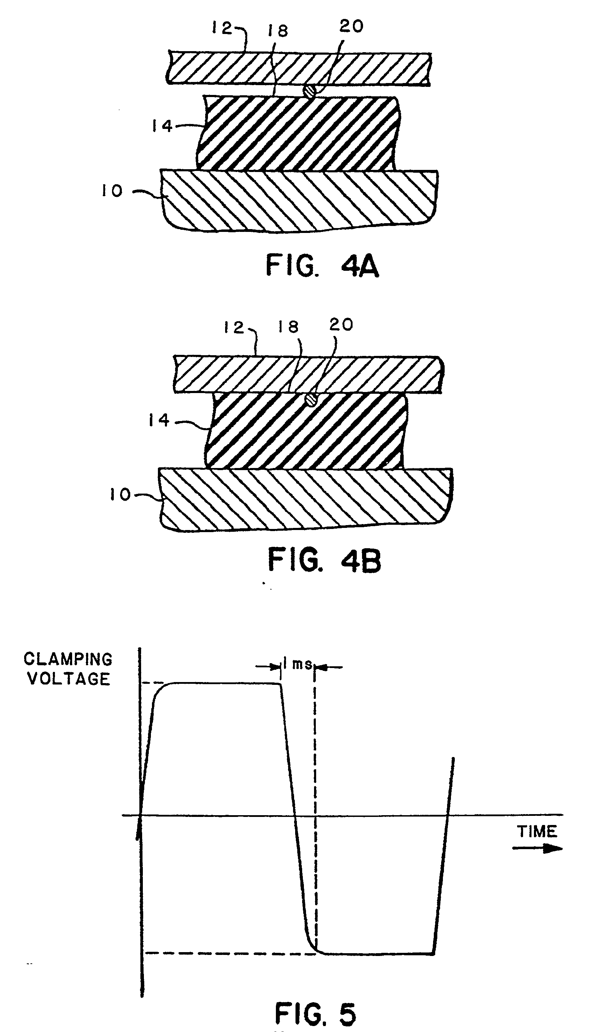

The thin wires 20, 22 and 24 provide line contacts with wafer 12. It has been found that point-contacts do not provide a reliable, low-resistance contact to the wafer, as required for automated semiconductor processing. Furthermore, the resilient dielectric layer 14 assists in maintaining a low resistance contact with wafer 12. When the wafer 12 is first positioned on clamping surface 18 and no clamping voltage is applied, the wires 20, 22 and 24 protrude at least slightly above clamping surface 18, as shown in Fig. 4A. Thus, the wires 20, 22 and 24 physically contact the wafer 12, at least along a portion of their lengths.

When the clamping voltage generator 40 is activated and the clamping voltage is applied, the wafer 12 is drawn against clamping surface 18, thereby pressing wires 20, 22 and 24 into resilient dielectric layer 14 and maintaining or increasing the length of electrical contact between wires 20, 22 and 24 and wafer 12. The resilience of dielectric layer 14 urges wires 20, 22 and 24 against wafer 12 to ensure that a reliable, low resistance contact is maintained. The line contact between wires 20, 22 and 24 and wafer 12 ensures initial contact when only the weight of the wafer 12 is available to provide the contacting force, in spite of the bulk resistance surface oxides and unipolar effects of surface doping of the wafer.

An enlarged, partial cross-sectional view of wafer 12, dielectric layer 14 and platen 10 is shown in FIG. 4B. The wafer 12 is shown in the clamped position. It is seen that the wire 20 is pressed into the resilient dielectric layer 14. The wafer 12 is not significantly deformed by the wire 20, and contact is maintained between wafer 12 and clamping surface 18 except for a very small region that is approximately equal in width to the diameter of wire 20. The soft, resilient layer 14 is believed to flow up and around wire 20 rather than forming a depression in which contact is not maintained between wafer 12 and clamping surface 18. The configuration shown in FIG. 4B has been confirmed using an optically-transparent, conductively-coated glass wafer. In order to achieve the configuration shown in FIG. 4B and described above, the ratio between the wire diameter and the thickness of dielectric layer 14 is preferably in the range of about 0.10 to 0.33.

The configuration shown in FIG. 1 utilizes three wires 20, 22 and 24 for establishing electrical contact with wafer 12. This configuration was utilized in the example of FIG. 1 to provide clearance for a wafer lift mechanism (not shown) located in the center portion of platen 10. However, any combination of one or more conductive strands or wires positioned on clamping surface 18 are included within the scope of the present invention. It will be understood that a single contact wire provides a line contact with wafer 12. As the number of contact wires is increased, the resistance of the electrical contact to wafer 12 is decreased and the clamping force in increased.

It has been found that the performance of the electrostatic wafer clamp of the invention depends in part on the characteristics of the clamping voltage. A DC clamping voltage provides reliable clamping but results in polarization of the interface between the wafer 12 and clamping surface 18 so that the wafer remains clamped to the surface 18 after the clamping voltage has been turned off. A preferred clamping voltage is a bipolar square wave voltage having a peak-to-peak amplitude of at least 1000 volts and a frequency in the range of less than one Hz to 300 Hz, as illustrated in FIG. 5 at 44. The bipolar square wave clamping voltage prevents charge buildup at the interface between wafer 12 and clamping surface 18.

In addition, it has been found desirable to limit the switching speed of the square wave clamping voltage to about 1000 volts per millisecond in order to prevent arcing between the wires 20, 22 and 24 and the wafer 12. The relatively slow switching time of the square wave clamping voltage reduces the current through the wafer-to-wire contact to values on the order of 1-10 milliamps. Techniques for generating clamping voltage waveforms of the type shown in FIG. 5 and described above are well known to those skilled in the art and will not be described in detail. It will be understood that the waveshape of the square wave clamping voltage depends on the circuit used for generating the clamping voltage. However, the switching speed of the square wave clamping voltage is preferably limited as described above. For example, a suitable clamping voltage can be obtained by clamping, or amplitude limiting, of a sine wave.

In an example of the present invention, a water-cooled aluminum platen was covered with an insulating layer of thermally-conductive silicone rubber having a thickness of 0.015 cm. The rubber layer was precision cast to ensure a flat surface with a smooth finish facing the wafer. The thickness of the rubber layer was carefully controlled to optimize thermal heat transfer between the wafer and the aluminum platen. A tungsten wire 0.0025 cm in diameter was lightly stretched over the platen tangent to the rubber surface. The wire was processed by conventional cleaning techniques to obtain a bright, oxide-free surface to minimize electrical contact resistance to the wafer.

This combination of materials and geometry required a clamping voltage in the 1000-2000 volt range to produce a clamping force in the range of 650-1350 Pa for use in both air and vacuum.

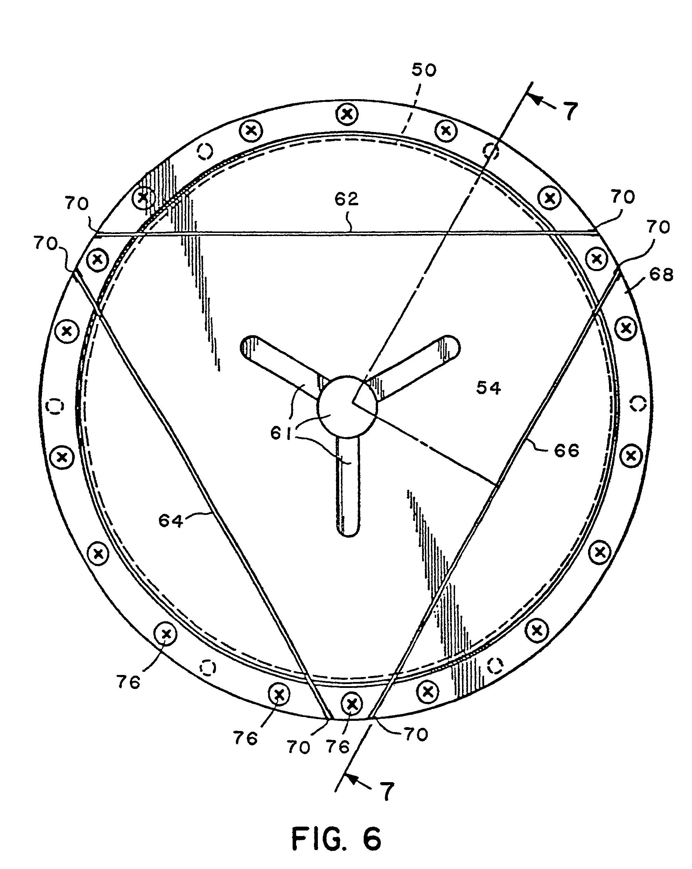

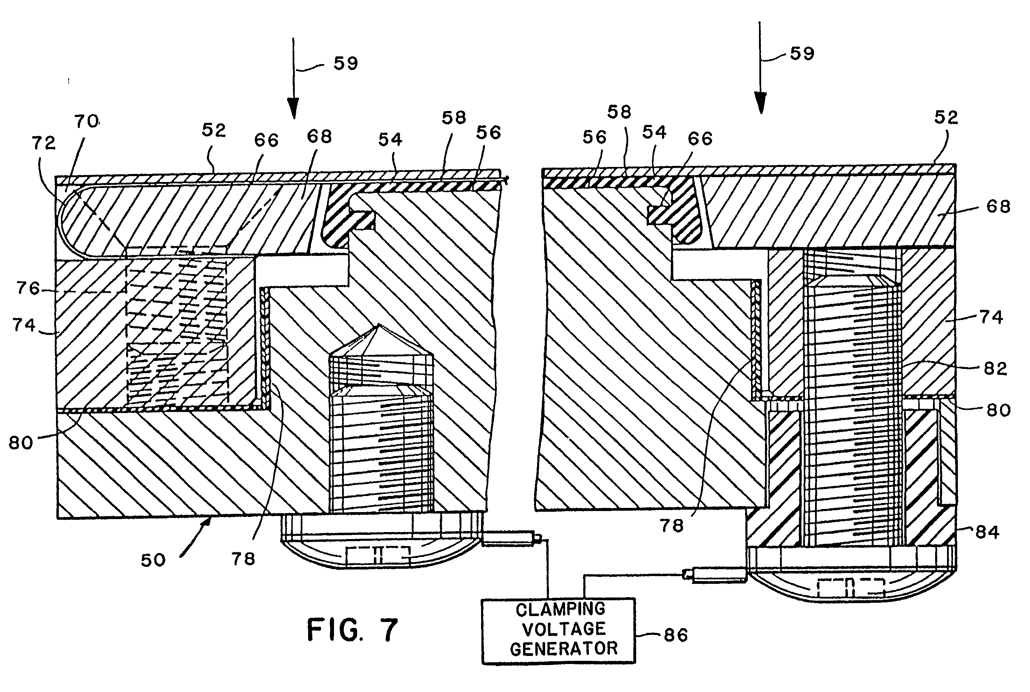

A preferred embodiment of an electrostatic wafer clamping apparatus in accordance with the present invention is shown in Figs. 6 and 7. An electrically conductive platen 50 provides mechanical support for a semiconductor wafer 52. A dielectric layer 54 is adhered to a flat surface 56 of platen 50. The dielectric layer 54 has a flat wafer clamping surface 58. The dielectric layer 54 can be a resilient, thermally-conductive silicone rubber as described hereinabove. The wafer 52 overlaps the outer edge of the dielectric layer 54 to prevent an incident ion beam 59 from damaging the dielectric layer 54 in the area of the wafer flat. The dielectric layer 54 is adhered to surface 56 and is molded into a groove 60 around the periphery of platen 50 to further insure that the dielectric layer 54 remains fixed to surface 56 during use. A central portion of platen 50 is provided with an opening 61 for a wafer lift mechanism (not shown).

Conductive wires 62, 64 and 66 are lightly stretched across clamping surface 58 and are attached to an annular support ring 68. Wires 62, 64 and 66 have the characteristics described above in connection with wires 20, 22 and 24. The ring 68 is provided with spaced-apart notches 70 for retaining wires 62, 64 and 66. Each notch 70 has a semicircular portion 72, as best shown in Fig. 7, to provide controlled bending of wires 62, 64 and 66. As shown in Fig. 7, wires 62, 64 and 66 are bent around the respective semicircular portions 72 and are retained between ring 68 and an annular ring 74 by machine screws 76. The rings 68 and 74 are electrically insulated from platen 50 by insulating spacers 78 and 80. The ring 74 is mechanically attached to platen 50 by machine screws 82 and insulating spacers 84 such that rings 68 and 74 and wires 62, 64, 66 are electrically isolated from platen 50. A clamping voltage generator 86 is connected between platen 50 and wires 62, 64, 66 via screw 82 and rings 68 and 74.

In operation, a clamping voltage as shown in Fig. 5 and described hereinabove is applied between wires 62, 64, 66 and platen 50 in order to securely clamp wafer 52 against dielectric layer 54.

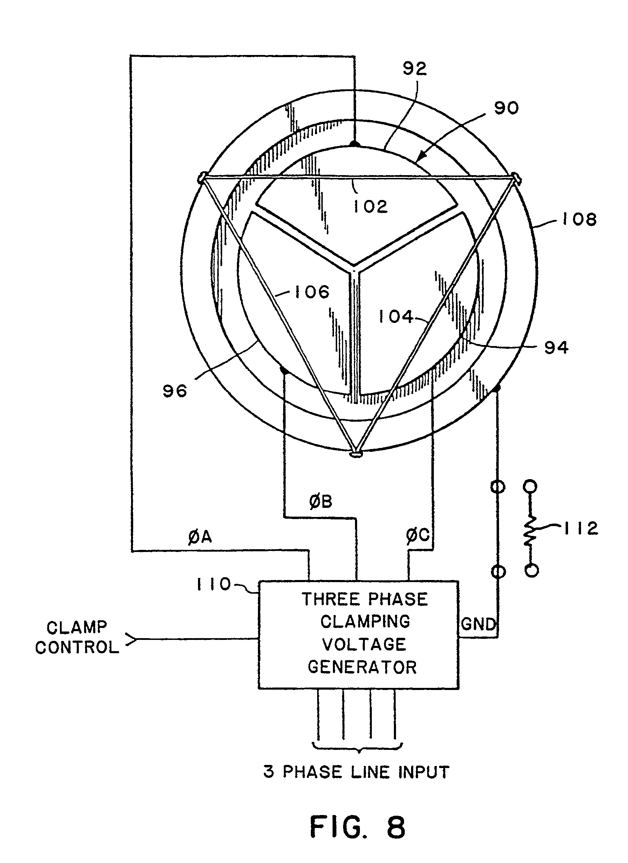

An alternate preferred embodiment of the invention is shown in FIG. 8. A wafer clamping apparatus includes a conductive platen 90 which is radially divided into sections 92, 94 and 96. The sections 92, 94 and 96 are electrically isolated from each other. A dielectric layer having the same characteristics as dielectric layer 14 shown and described hereinabove is affixed to the surfaces of platen sections 92, 94 and 96. Wires 102, 104 and 106, having the same characteristics as wires 20, 22 and 24 shown and described hereinabove, extend across platen 90 and are electrically connected to a frame member 108. The frame member 108 is electrically isolated from platen 90. A three-phase clamping voltage generator 110 has a phase A ($\phi$A) output connected to platen section 92, a phase B ($\phi$B) output connected to platen section 96 and a phase C ($\phi$C) output connected to platen section 94. The ground line of the voltage generator 110 is connected to the frame member 108.

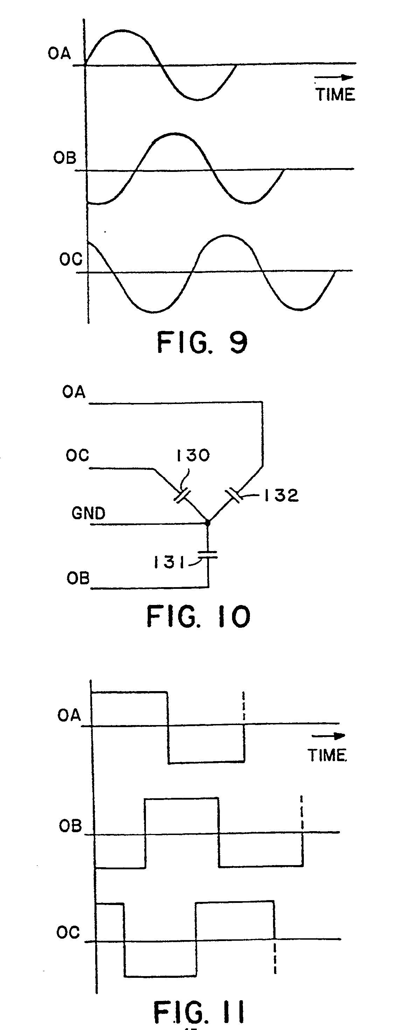

According to one configuration of the three-phase wafer clamping apparatus, the outputs of the three-phase clamping voltage generator 110 are sine waves as shown in Fig. 9. The three phases are shifted relative to each other by 120° in conventional fashion.

The wafer clamping apparatus shown in FIG. 8 provides highly efficient thermal transfer when the dielectric layer is a thermally-conductive silicone rubber as described hereinabove in connection with dielectric layer 14 and in the aforementioned U.S. Patent No. 4,832,781.

An equivalent circuit of the three-phase wafer clamping apparatus is shown in Fig. 10. Platen sections 92, 94 and 96 and the wafer are equivalent to a Y-connected configuration of capacitors 130, 132 and 134 as shown in Fig. 10. As shown in Fig. 8, the wafer is connected to ground. The wafer corresponds to the plates of the capacitors 130, 132 and 134 which are connected to ground. Capacitor 130 represents capacitance between the wafer and platen section 94; capacitor 132 represents the capacitance between the wafer and platen section 92; and capacitor 134 represents the capacitance between the wafer and platen section 96. The wafer clamping apparatus appears to the three-phase voltage as a symmetrically-matched, Y-connected three-phase load. It is well known in the field of three-phase power distribution that when a three-phase, Y-configured distribution system is connected to a symmetrical, Y-configured load, the neutral current from the center of the load to the neutral of the system is zero. This principle is described by F.D. Hehre et al. in Electrical Circuits And Machinery, Wiley & Sons, 1942, pp. 150-165. The fact that the current in the ground line is zero for such a configuration is important in the context of a wafer clamping apparatus. Since the ground current is zero, the connection to the wafer provided by wires 102, 104 and 106 can be removed without affecting clamping operation. Thus, the difficulties associated with making a low resistance electrical contact to a semiconductor wafer are eliminated.

A further advantage of the three-phase wafer clamping apparatus shown in Fig. 8 is that a constant clamping force is provided at all times. The holding force is proportional to the sum of the individual phase voltages squared. By contrast, in a single phase electrostatic wafer clamp, the clamping force goes to zero each time the clamping voltage crosses zero voltage. While this has not been found to be a problem in practice, the three-phase configuration eliminates potential loss in clamping force during zero crossings of the clamping voltage. Furthermore, the three-phase configuration can be used to provide a more fail-safe system. When the clamping voltage fails in a single phase system, an expensive semiconductor wafer can be damaged or destroyed. In the three-phase wafer clamping apparatus, some clamping force remains when one or two phases are lost. The three phases of the clamping voltage can be monitored. When one or two of the phases are lost, operation can be terminated without damage to the wafer.

As discussed above, the ground connection to the semiconductor wafer can be removed in the three-phase wafer clamping apparatus. In practice, however, it is usually preferable to provide a ground contact to the wafer in the form of wires 102, 104 and 106 or an equivalent low resistance connection. A zero value of ground current occurs only for perfectly balanced, three-phase sine wave voltages operating into perfectly matched loads. That is, each of the equivalent capacitors 130, 132 and 134 shown in Fig. 10 must be equal in value. In practice, there is usually a slight unbalance in the system. However, even when the system is somewhat unbalanced, the groud current is very small, and the chance of arcing to the wafer is minimal. A further advantage of utilizing the groud connection provided by wires 102, 104 and 106 is that the ground connection minimizes charge buildup due to the incident ion beam and provides a means for measuring the ion beam current incident on the semiconductor wafer. When it is desired to monitor ion beam current incident upon the wafer, a resistor 112 can be connected in series with the ground line as shown in Fig. 8.

When a three-phase sine wave clamping voltage is utilized in the wafer clamping apparatus of Fig. 8, the appropriate clamping voltages can be derived in voltage generator 110 directly from a three-phase line input. Step-up transformers can be utilized to provide the required clamping voltage amplitude, on the order of 1,000 volts pead-to-peak. Relays or other suitable analog switches can be utilized to turn the clamping voltage on and off.

According to another aspect of the three-phase wafer clamping apparatus shown in Fig. 8, the three-phase clamping voltage can comprise square waves as shown in Fig. 11. The phase A, phase B, and phase C outputs of the clamping voltage generator 110 are square waves shifted relative to each other by one third of the square wave oscillation period. Preferably, the switching rate of the three-phase square wave clamping voltage is limited to about 1,000 volts per millisecond as shown in Fig. 5 and described hereinabove. The use of square waves as shown in Fig. 11 provides a greater clamping force than sine waves of same amplitude. Thus, an equivalent clamping force can be obtained with square waves of smaller amplitude in comparison with sine waves.

Since the ground current is zero only for a three-phase sine wave system, the ground current is nonzero when a three-phase square wave clamping voltage is utilized. However, the magnitude of the ground current is generally much smaller than in the case of a single phase system, thereby reducing the risk of arcing. Furthermore, when either a sine wave or a square wave three-phase clamping voltage is utilized, the wafer can be reliably clamped even when the contact resistance between the ground wires 102, 104 and 106 and the semiconductor wafer is high.

The three-phase wafer clamping apparatus of FIG. 8 has been shown and described with wires 102, 104 and 106 for making electrical contact to the wafer. It will be understood that any suitable technique can be utilized for making electrical contact to the wafer in the three-phase configuration and that such three-phase wafer clamping configurations are included within the scope of the invention.

The embodiment of Fig. 8 has been described in connection with a three-phase system wafer clamping apparatus. A three-phase system is the preferred configuration of a polyphase clamping system since three-phase line voltages are frequently available. However, a two-phase clamping system provides acceptable performance, particularly for relatively low clamping voltages. Furthermore, electrostatic wafer clamps utilizing a clamping voltage with more than three phases are included within the scope of the present invention.

The silicone rubber dielectric layer performs several important functions in the electrostatic wafer clamping apparatus of the invention. The silicone rubber layer electrically insulates the wires 20, 22, 24 and wafer 12 from the platen 10 potential. A silicone rubber layer having a thickness of 0.015 cm has been tested in vacuum with 2000 volts across the rubber layer without failure. The silicone rubber layer also provides a distributed compressive force against the wires 20, 22 and 24 to establish a long, thin line contact with the back surface of wafer 12 that ensures electrical contact.

The silicone rubber layer exhibits wafer cooling capability of several watts per square centimeter when compressed by the electrostatic clamping force in accordance with the invention. It will be understood, however, that the dielectric layer used in the electrostatic wafer clamping assemblies which are shown and described herein is not necessarily thermally-conductive. When cooling of the wafer is not required, the dielectric layer can be a thermal insulator without affecting the clamping operation of the assembly.

Finally, the silicone rubber layer exhibits elastic flow and compressive properties that permit the wires 20, 22, 24 to be pressed into the space occupied by the rubber layer without distorting the wafer 12 or interrupting the contact between the clamping surface 18 and the wafer 12, except in a region approximately equal in width to the d/meter of the wires.

The apparatus described provides a number of important features. The apparatus provides apparatus for establishing a simple back surface, low-resistance contact to a wafer. The use of one or more wires establishes a large surface area electrical contact over an area proportional to the wafer size, thus minimizing current concentration in the bulk of the wafer and at contact points. The contact is distributed over the rear of the wafer, thereby ensuring short conduction paths through the body of large wafers. The clamping technique is completely free of clamping rings or other devices which obstruct the front surface of the wafer, thus permitting very shallow angle implants. The clamping apparatus holds a wafer securely against a flat cooling platen during high power implant processing, thus making possible uniform implant angle processing across the wafer surface. The configuration which utilizes one or more fine wires positioned between the wafer and the clamping surface of the thermally-conductive, electrically-insulating, soft, pliable silicone rubber platen produces a negligible change in the cooling performance relative to a platen that does not utilize wires. Each wire compresses the soft rubber with minimal distortion of the wafer so that the wafer remains flat. The restoring force from the compressed rubber tends to press the fine wire against the wafer surface, thereby causing optimum conformance of the wire to the more rigid wafer surface. The electrical contact between the wire and the wafer is thereby enhanced.

The thermally-conductive silicone rubber exhibits efficient heat transfer and superior electrical insulation and dielectric properties for electrostatic clamping. The pliable, nearly plastic flow of the silicone rubber ensures that the rubber flows into and conforms to the surface contours of the silicon wafer, thus ensuring intimate contact between the wafer and the rubber. The dielectric permittivity and dielectric strength of the silicone rubber are more than adequate to achieve the required physical holding force for wafer handling and cooling. The additives used to increase the thermal conductivity of the silicone rber also raise the permittivity of the rubber, thus, increasing the holding force for a given applied voltage.

## Claims

1. Apparatus for electrostatic clamping of a workpiece, Comprising:

   platen means including at least two platen sections each comprising a conductive material and being electrically isolated from each other;

   a dielectric material disposed on said sections, the dielectric material having a clamping surface for receiving a workpiece, and

   means for applying a polyphase clamping voltage to said platen means, the phases of said polyphase clamping voltage being applied to respective platen sections.

2. Apparatus as claimed in Claim 1 wherein said platen sections include surfaces in contact with said dielectric material that are approximately equal in area.

3. Apparatus as claimed in Claim 1 further including conductive means connected between said workpiece and a ground conductor of said polyphase voltage.

4. Apparatus as claimed in Claim 3 wherein said conductive means comprises at least one thin wire disposed on said clamping surface between said dielectric material and said workpiece.

5. Apparatus as claimed in any one of the preceding Claims wherein said dielectric material comprises a resilient dielectric layer affixed to said at least two platen sections.

6. Apparatus as claimed in Claim 5 wherein said resilient dielectric layer is thermally-conductive.

7. Apparatus as claimed in any of the preceding Claims wherein said clamping surface is substantially flat.

8. Apparatus as claimed in any one of Claims 1 to 7 wherein each phase of said polyphase clamping voltage comprises a sinusoidal voltage.

9. Apparatus as claimed in any one of Claim 1 to 7 wherein each phase of said polyphase clamping voltage comprises a bipolar square wave voltage.

10. Apparatus as claimed in Claim 9 wherein said square wave voltage has a switching rate up to 1000 volts per millisecond.

FIG. 1

FIG. 2

CLAMP CONTROL

CLAMPING VOLTAGE GENERATOR

FIG. 3

CLAMP CONTROL

CLAMPING VOLTAGE GENERATOR

FIG. 4A

FIG. 4B

FIG. 5

FIG. 6

FIG. 7

CLAMPING VOLTAGE GENERATOR

FIG. 8

FIG. 9

FIG. 10

FIG. 11

European Patent
Office

**EUROPEAN SEARCH REPORT**

Application Number

EP 91 30 5124

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | WO-A-8 809 054 (LABTAM)<br>* abstract; figures 1-4 * | 1-3,7-9 | H01L21/68<br>H01L21/00<br>H02N13/00 |
| Y | | 5,6 | |
| | --- | | |
| D,Y | WO-A-7 900 510 (VEECO)<br>* abstract; figures 1-4 * | 5,6 | |
| | --- | | |
| X | US-A-4 520 421 (HITACHI)<br>* abstract; figures 1,7-9 *<br>* column 3, line 62 - line 65 * | 1,2 | |
| | ----- | | |

**TECHNICAL FIELDS SEARCHED (Int. Cl.5 )**

H01L
H02N

The present search report has been drawn up for all claims

| Place of search | Date of completion of the search | Examiner |
|---|---|---|
| THE HAGUE | 17 SEPTEMBER 1991 | PROHASKA G. A. |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P0401)